# EUROPEAN PATENT SPECIFICATION

(11) **EP 0 473 367 B1**
(45) Date of publication and mention of the grant of the patent: **17.01.1996**
(21) Application number: 91307749.1
(22) Date of filing: 22.08.1991
(51) Int. Cl.: H03M 7/30

(54) **Digital signal encoders**
Digitaler Signalverschlüssler
Codeur de signal numérique

(30) Priority: 24.08.1990 JP 221366/90
(43) Date of publication of application: 04.03.1992
(73) Proprietor: SONY CORPORATION, Tokyo 141 (JP)
(72) Inventor: Akagiri, Kenzo, c/o Patents Div., Shinagawa-ku Tokyo (JP); Tsutsui, Kyoya, c/o Patents Div., Shinagawa-ku Tokyo 131 (JP)
(74) Representative: Harris, Ian Richard

(56) References cited:
- EP-A- 0 193 143
- EP-A- 0 400 473

## Description

This invention relates to digital signal encoders.

For efficient coding of audio signals or the like, there are coding techniques based on bit assignment, wherein an input audio signal is divided into signal components of a plurality of channels on the time axis or the frequency axis, and the number of bits is adaptively allocated to respective channels. For example, there are coding techniques such as band division coding (sub-band coding: SBC) to divide an audio signal on the time axis into signal components in a plurality of frequency bands to carry out coding thereof; adaptive transform coding (ATC) for transforming (orthogonal-transforming) a signal on the time axis to a signal on the frequency axis thereby to divide that signal into signal components in a plurality of frequency bands adaptively to carry out coding in respective bands; adaptive bit allocation (APC-AB) in which SBC and adaptive predictive coding (APC) are combined to divide a signal on the time axis into signal components in a plurality of bands to transform signal components in respective bands to those in a base band (low frequency band), thereafter to carry out a linear predictive analysis; and the like.

Efficient coding techniques in which the masking characteristic in the hearing of a human being is taken into consideration have been attempted. The masking effect is the phenomenon that a signal is masked by another signal, so it cannot be heard. The masking effect may occur on the time axis or on the frequency axis.

The masking phenomenon on the frequency axis is the effect that a signal component in a frequency band is masked by a signal component in another frequency band, so the former signal component cannot be heard. As the masking effect on the time axis, there are the temporal masking effect and the simultaneous masking effect. The simultaneous masking effect is the effect that a small sound occurring simultaneously with a loud sound is masked by the loud sound, so it cannot be heard. The temporal masking effect is the effect that small sounds preceding and succeeding a loud sound are masked by the loud sound, so they cannot be heard. The masking backward in time by the loud sound is called forward masking, and the masking forward in time by the loud sound is called backward masking. In temporal masking, from the viewpoint of human hearing, the effect of forward masking is effective for a long time (for example, about 100 msec), whereas the effect of backward masking is effective for a short time (for example, about 5 msec). In addition, the level of the masking effect is about 20 dB for forward masking, and is about 30 dB for backward masking. As stated above, since sound subjected to masking cannot be heard, then even if the number of bite allocated for quantization of a masked signal component is reduced in quantization of an audio signal, perceived deterioration can be lessened.

From EP-A-0193 143 there is known a digital signal encoder wherein the audio signal is processed by analogue to digital conversion, windowing, i.e. sampling of 20 ms blocks, pre-processing fast Fourrier transform analysis of frequency spectrum, and encoding according to psycho-acoustic aspects, i.e. irrelevant frequency components are weighted accordingly or discarded by means of a computer.

For more efficient coding the b t compression ratio must be increased. However, generally, in carrying out bit compression making use of the masking effect, only the masking effect in signals on the frequency axis or the masking effect in signals on the time axis can be used.

In addition, in reducing the bit rate due to the masking effect on the time axis, it is desirable for effectively utilizing the masking effect on the time axis to allow the processing time block length to be long. However, this makes real time processing difficult.

According to the present invention there is provided a digital signal encoder comprising:
first frequency analysis means of the non-block type for carrying out frequency analysis of an input digital signal;
second frequency analysis means of the block type for further carrying out frequency analysis of frequency components analyzed by said first frequency analysis means;
first noise level setting means for setting a first allowable noise level on the basis of the energy of each frequency component within a predetermined time period of outputs from said second frequency analysis means;
second noise level setting means for setting a second allowable noise level of each frequency component within said predetermined time period on the basis of the energy of at least one of data preceding in time and data succeeding in time outputs from said second frequency analysis means; and
quantization means for quantizing an output from said second frequency analysis means;
a quantization characteristic of said quantization means being set on the basis of outputs from said first and second noise level setting means.

Embodiments of the invention can provide a digital signal encoder which can carry out real time processing with little deterioration in sound quality, by effectively utilizing both the masking effect with respect to signals on the frequency axis and the masking effect with respect to signals on the time axis, thus permitting the bit rate to be reduced.

The invention will now be described by way of example with reference to the accompanying drawings. throughout which like parts are referred to by like references, and in which:
Figure 1 is a block diagram of a digital signal encoder according to this invention;
Figure 2 is a block circuit of a filter bank;
Figure 3 is a diagram for explaining blocks and predetermined time periods in the embodiment;
Figure 4 is a diagram showing the bark spectrum;
Figure 5 is a circuit diagram showing the filter circuit;
Figure 6 is a diagram showing a masking spectrum; and
Figure 7 is a diagram in which the minimum audible curve and the masking spectrum are synthesized.

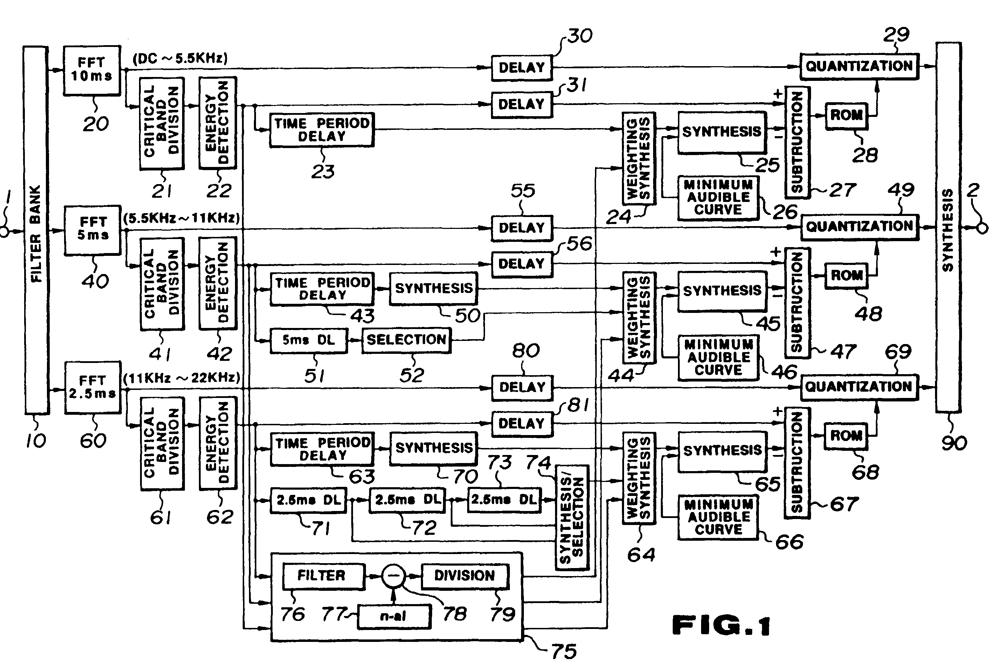

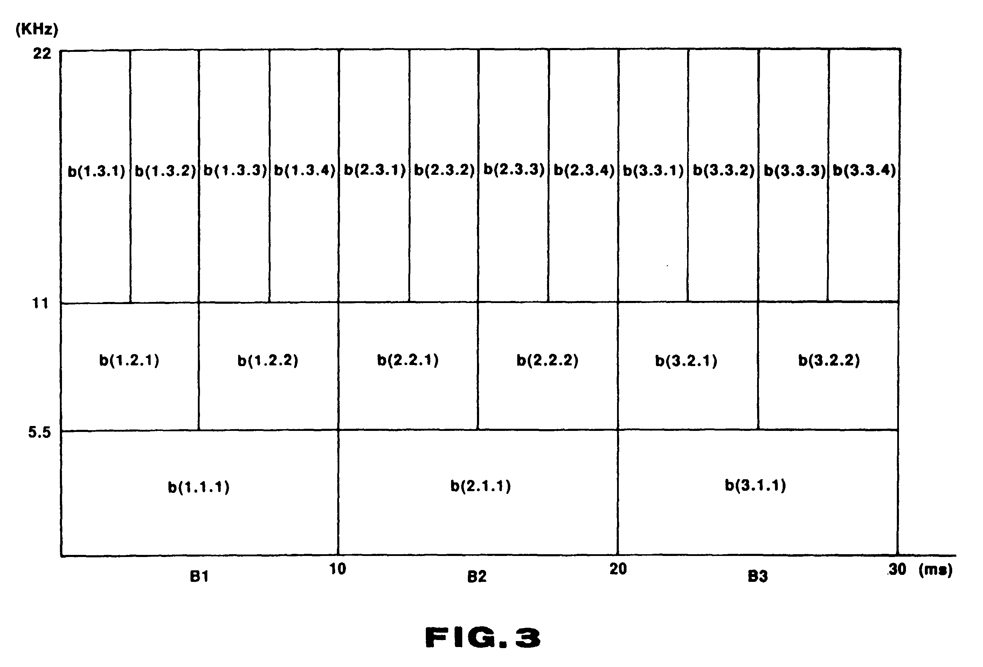

An embodiment of digital signal encoder comprises, as shown in Figure 1, a filter bank 10 serving as first frequency analysis means of the non-block type for carrying out frequency analysis of an input digital signal supplied to an input terminal 1, fast Fourier transform (FFT) circuits 20, 40 and 60 serving as second frequency analysis means of the block type for further carrying out frequency analysis of frequency components analyzed by the filter bank 10, and quantization circuits 29, 49 and 69 for quantizing respective outputs (FFT coefficient data) from the FFT circuits 20, 40 and 60. A masking spectrum calculation circuit 75 serves as first noise level setting means for setting a first allowable noise level on the basis of energies of respective frequency components within predetermined time periods (for example, time periods B1 to B3 ... of Figure 3 which will be described later) of outputs from the FFT circuits 20, 40 and 60; and time period delay circuits 23, 43 and 63, synthesis circuits 50 and 70, a 5 ms delay (DL) circuit 51, 2.5 ms delay circuits 71, 72 and 73, a selection circuit 52, a synthesis/selection circuit 74, and weighting synthesis circuits 24, 44 and 64 serve as second noise level setting means for setting second allowable noise levels of respective frequency components for the predetermined time periods on the basis of an energy of at least one of data preceding in time and data succeeding in time the predetermined time periods, thus to set quantization circuits 29, 49 and 69 on the basis of outputs from the first and second noise level setting means. The filter bank 10 comprises band division means for dividing the input digital signal into signal components in a plurality of frequency bands (three bands in this embodiment), including at least one filter (for example, a mirror filter such as a so-called QMF). The FFT circuits 20, 40 and 60 carry out fast Fourier transformation of signals every block. The band division means (filter bank 10) carries out a division such that the bandwidth becomes larger as the frequency band shifts to a higher frequency. The FFT circuits 20, 40 and 60 carry out processing such that the block time length where the fast Fourier transform processing is carried out becomes smaller as the frequency band shifts to a higher frequency. At least one datum at the second noise level setting means is caused to be data preceding in time. In addition, the second noise level setting means sets the second noise level on the basis of energies of data which are the same in terms of the frequency components for periods different in time. An output from the encoder is derived from an output terminal 2.

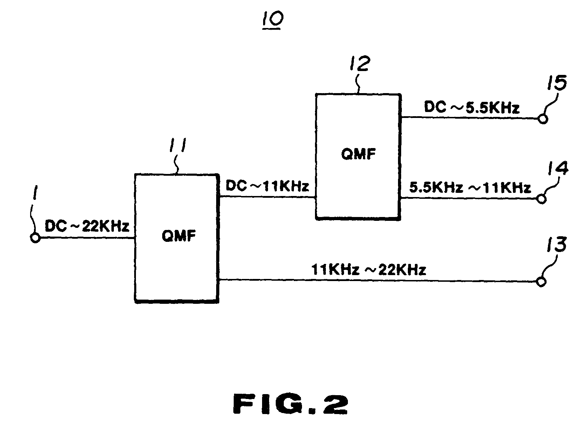

An input digital audio signal of DC to 22 KHz obtained by sampling, for example at the sampling frequency fs = 44.1 KHz is supplied to the input terminal 1 and thence to the filter bank 10. The filter bank 10 includes, as shown in Figure 2, two stages of QMFs 11 and 12 cascade-connected. The input digital audio signal is supplied to the QMF 11 which divides it into signal components in two frequency bands meeting at 11 KHz. Accordingly, output signals in the frequency bands of DC to 11 KHz and 11 to 22 KHz are provided from the QMF 11. The output signal 11 to 22 KHz is supplied to the FFT circuit 60 through a terminal 13. On the other hand, the output signal DC to 11 KHz is supplied to the QMF 12 which divides an input signal into signal components in two frequency bands meeting at 5.5 KHz. Accordingly, output signals in the frequency bands of DC to 5.5 KHz and 5.5 to 11 KHz are provided from the QMF 12. The signal 5.5 to 11 KHz is supplied to the FFT circuit 40 through a terminal 14, and the signal DC to 5.5 KHz is supplied to the FFT circuit 20 through a terminal 15. Thus, in the filter bank 10 serving as the first frequency analysis means, an input digital sound signal is divided into signal components in three frequency bands on a non-block basis so that the bandwidth becomes larger as the frequency band shifts to a higher frequency. It is to be noted that while the filter comprises QMFs in the example of Figure 2, there may be employed a structure using band-pass filters.

In the FFT circuit 20 supplied with a signal in the frequency band of DC to 5.5 KHz from the filter bank 10, the signal is divided into signal components in the form of blocks every 10 ms to carry out FFT processing every block. In the FFT circuit 40 supplied with a signal in the frequency band of 5.5 to 11 KHz, FFT processing on a block basis every 5 ms is carried out. In the FFT circuit 60 supplied with a signal in the frequency band of 11 to 22 KHz, FFT processing on a block basis every 2.5 ms is carried out. Thus, in the FFT circuits 20, 40 and 60 serving as the second frequency analysis means, processing such that the block length subjected to FFT becomes smaller as the frequency band shifts to a higher frequency is carried out. As stated above, in this embodiment, in forming blocks at respective FFT circuits 20, 40 and 60, the time block length is smaller at a higher frequency band thereby to allow the time resolution at the higher frequency band to be high and allow the time resolution at the lower frequency band to be low to increase the number of samples within one block, thus allowing the frequency resolution to be high. Thus, since ordinary audio signals have short steady state periods in a high frequency band, it is appropriate that the time resolution in a high frequency band is caused to be high as described above. Moreover, since the frequency resolution of human hearing is generally high in a low frequency band, it is also appropriate that the frequency resolution in a low frequency band is caused to be high as described above.

The time block of the processing by the filter bank 10 and the respective FFT circuits 20, 40 and 60 is shown in Figure 3. Thus, in Figure 3, there are shown the band division and respective processing units (blocks) of FFT, etc, and respective blocks are designated by three parameters p, q and r, shown b (p, q, r) in the figure, where p represents elapsed time, q represents a band, and r represents a time block. In Figure 3, it is indicated that one time block in each band has a time length (time resolution) of 10 ms in the lower frequency band DC to 5.5 KHz. It is also indicated that one time block length is 5 ms in the medium frequency band 5.5 to 11 KHz, and that one time block length is 2.5 ms in the high frequency band 11 to 22 KHz.

FFT coefficient data of every band obtained by FFT processing in the FFT circuits 20, 40 and 60 are supplied to the quantization circuits 29, 49 and 69, where they are quantized. At this time, for example, in every respective predetermined time period B1 to B3 ... of Figure 3, quantization processing is carried out. In this quantization, there is carried out an adaptive quantization in which the quantization characteristic (bit allocation) of quantization is changed on the basis of outputs from the first and second noise level setting means obtained in consideration of the masking effect with respect to signals on the frequency axis, and the masking effect with respect to signals on the time axis as described later. It is here noted that the respective predetermined time periods B1 to B3 ... are set to 10 ms which is the minimum unit of the processing at the FFT circuit 20.

The first and second allowable noise levels for carrying out such an adaptive quantization are determined in practice as follows.

Output data of the FFT circuits 20, 40 and 60 are further divided into data in so-called critical bands. The critical band here mentioned is a band in which human hearing is taken into consideration. More particularly, when a pure sound is masked by a narrow band noise having the same intensity including a pitch of the pure sound, the critical band refers to a band of a noise such that the bandwidth becomes broad as the frequency band shifts to a higher frequency. In this embodiment, such a critical band division is employed thereby to allow the bandwidth to be broader as the frequency band shifts to a higher frequency, thus to divide the band concerned into, for example, 25 bands. To carry this out, output data (frequency band DC to 5.5 KHz) from the FFT circuit 20 are further divided into data in, for example, 20 bands on the side of the low frequency band of the critical band by the critical band division circuit 21. Moreover, output data (5.5 to 11 KHz) from the FFT circuit 40 are further divided into data in, for example, 3 bands in a medium frequency band of the critical band by the critical band division circuit 41. In addition, output data (11 to 22 KHz) from the FFT circuit 60 are further divided into data in, for example, two bands in a high frequency band of the critical band by the critical band division circuit 61.

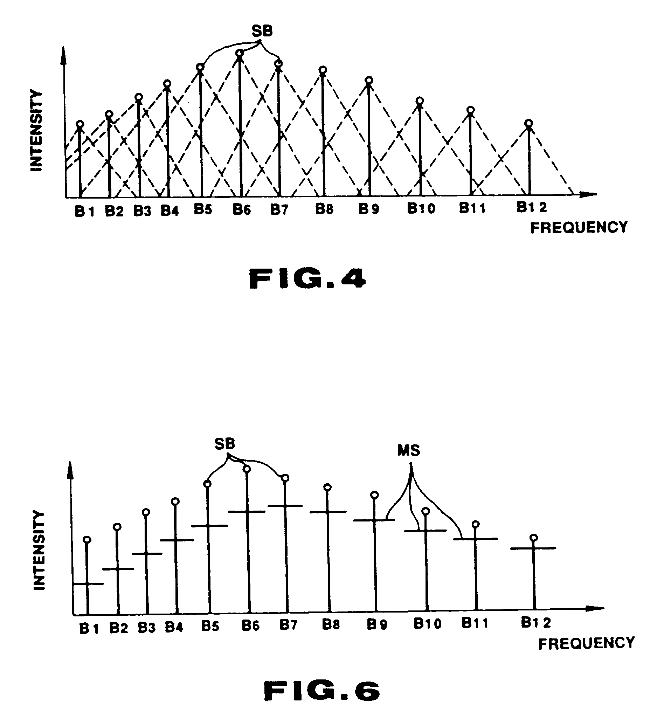

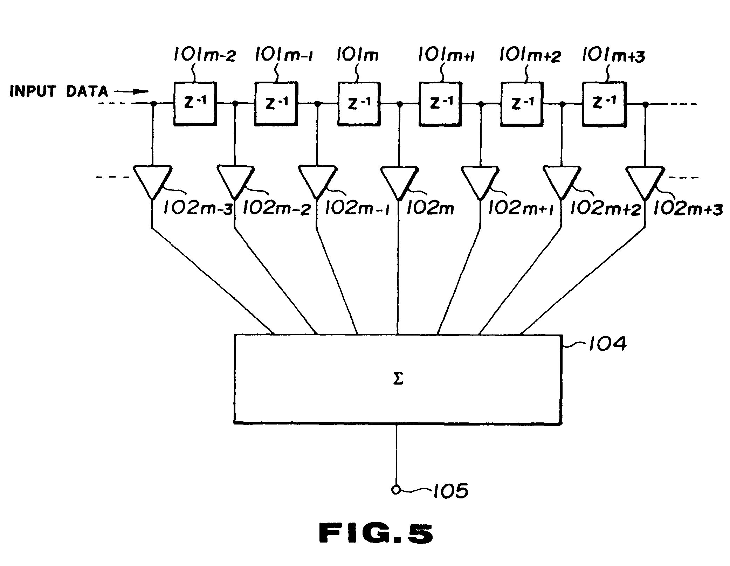

Outputs from the critical band division circuits 21, 41 and 61 are supplied to energy detection circuits 22, 42 and 62, respectively. In the respective energy detection circuits 22, 42 and 62, energies (spectrum intensities in respective bands) of data every respective time block, and respective critical bands at the FFT circuits 20, 40 and 60 are determined, for example, by taking a sum total of amplitude values in respective bands (the peak or average of the amplitude value, or energy sum total). Outputs from the energy detection circuits 22, 42 and 62, that is, the spectrum of the sum total every respective critical band is generally called a bark spectrum. The bark spectrum SB in each band is as shown in Figure 4, for example. It is to be noted that the above-mentioned critical band is represented as 12 bands for brevity of explanation in Figure 4.

Here, in order to allow the influence in the masking on the frequency axis of the bark spectrum SB to be taken into consideration, a predetermined weighting function is convoluted onto the bark spectrum SB. To realize this, outputs from the energy detection circuits 22, 42 and 46, that is, respective values of the bark spectrum SB are supplied to the masking spectrum calculation circuit 75 serving as the first noise level setting means. The masking spectrum calculation circuit 75 includes a filter circuit 76, a function generation circuit 77, a subtracter 78, and a divider 79 respectively corresponding to the energy detection circuits 22, 42 and 62. Accordingly, the outputs from each of the energy detection circuits 22, 42 and 62 is supplied to the filter circuit 76. The filter circuit 76 is, as shown in Figure 5, for example, composed of delay (Z⁻¹) elements .. 101ₘ₋₃ to 101ₘ₊₃ ... for delaying input data in sequence, multipliers ... 102ₘ₋₃ to 102ₘ₊₃ ... for multiplying outputs from respective delay elements by a filter coefficient (weighting function), and a sum total adder 104. At this time, at the respective multipliers 102ₘ₋₃ to 102ₘ₊₃, the convolution processing of the bark spectrum SB is carried out as follows. For example, at the multiplier 102ₘ₋₃, outputs from respective delay elements are multiplied by the filter coefficient 0.0000086; at the multiplier 102ₘ₋₂, those outputs are multiplied by the filter coefficient 0.0019; at the multiplier 102ₘ₋₁, those outputs are multiplied by the filter coefficient 0.15; at the multiplier 102ₘ, those outputs are multiplied by the filter coefficient 1; at the multiplier 102ₘ₊₁, those outputs are multiplied by the filter coefficient 0.4; at the multiplier 102ₘ₊₂, those outputs are multiplied by the filter coefficient 0.06; and at the multiplier 102ₘ₊₃, those outputs are multiplied by the filter coefficient 0.007. By the convolution processing mentioned above, the sum total of the portions indicated by dotted lines in Figure 4, added by the adder 104 is taken. The sum total thus provided is outputted from the output terminal 105.

Meanwhile, in the level a corresponding to the first allowable noise in the case of calculating the masking spectrum of the bark spectrum SB (allowable noise spectrum), if the level a is small, the masking spectrum (masking curve) with respect to signals on the frequency base will be lowered. As a result, the number of bits allocated in quantization at the quantization circuits 29, 49 and 69 must be increased. In contrast, if the above-mentioned level a is large, the masking spectrum will be raised. As a result, the number of bits allocated in quantization can be decreased. It is to be noted that the level a corresponding to the first allowable noise level refers to a level such that there results the first allowable noise level in every band of the critical band, by carrying out the deconvolution processing as described later. Moreover, generally in audio signals, etc, the spectrum intensity (energy) in the high frequency band portion is small. Accordingly, in this embodiment, a technique is adopted taking the above circumstances into consideration to allow the level a to be larger as the frequency band shifts to a higher frequency where the energy is small, thus to decrease the number of bits allocated at the high frequency band portion. From the above point of view, at the masking spectrum calculation circuit 75, the above-mentioned level a with respect to the same energy is set to a higher value as the frequency becomes higher.

Thus, in the encoder of this embodiment, the approach employed is to calculate the level a corresponding to the first allowable noise level, to effect a control such that the level a becomes high as the frequency band shifts to a higher frequency. To realize this, an output from the filter circuit 76 is supplied to the subtracter 78 which serves to determine the level a in the convoluted region. Here, an allowable function (a function representing the masking level) for determining the level a is supplied to the subtracter 78. By increasing and decreasing the allowable function, control of the level a is carried out. This allowable function is supplied from the function generation function 77.

When the number given in sequence from the low frequency band of the critical band is assumed to be 1, the level a corresponding to the allowable noise level can be determined in accordance with the following equation (1):$\text{a = S - (n - ai)}$

In equation (1), n and a are constants, respectively, where a > O, S is the intensity of the convolution-processed bark spectrum, and (n - ai) is an allowable function. Here, as described above, since a method of decreasing the number of bits from the high frequency band having less energy is advantageous to reduce the total number of bits, n is set to 38, and a is set to 1 in this embodiment. There is then no deterioration in sound quality, and satisfactory coding is carried out.

In this way, the above-mentioned level a is determined. These data are transmitted to the divider 79 which carries out deconvolution of the level a in the above-mentioned convolution-processed region. Accordingly, by carrying out the deconvolution processing, a masking spectrum can be provided from the level a. Namely, this masking spectrum can be provided from the level a. Namely, this masking spectrum becomes an allowable noise spectrum determined for every band. It is to be noted that while the above-mentioned deconvolution processing requires a complicated calculation, the simplified divider 79 is used in this embodiment to carry out the deconvolution.

In this encoder, the number of bits allocated for quantization in which the above-described masking on the frequency base is taken into consideration is determined, and a second allowable noise level of each frequency component for a predetermined time period is set on the basis of an energy of at least one of data preceding in time and data succeeding in time for the predetermined period of outputs from the FFT circuits 20, 40 and 60. Thus, assuming that the above-mentioned predetermined period is B2 of Figure 3, the data preceding in time becomes data for a predetermined time period B1, and the data succeeding in time becomes data for a predetermined time period B3. On the basis of at least one of data for these predetermined periods B1 and B3, an allowable noise level (masking level) with respect to each frequency component within the predetermined period B2 is set. Further, at least one data at the second noise level setting means is caused to be data preceding in time. Namely, by taking into consideration the forward masking in which the time of the masking effect is long in the temporal masking, on the basis of data for the predetermined time period B1 preceding in time, an allowable noise level for a predetermined time period B2 is determined. Further, the second noise level setting means sets the second allowable noise level on the basis of energies of data which are the same in terms of the frequency components for periods different in time. Namely, the second allowable noise level is set on the basis of energies of data preceding and succeeding in time of the same frequency band of the critical bands.

In other words, in the second noise level setting means, by taking into consideration the temporal masking by signals preceding and succeeding (for preceding and succeeding predetermined time periods B1 and B3) on the time base adjacent on the time base to a signal at a current time point (for example, a predetermined time B2) of an arbitrary band where the first allowable noise level is set by the masking spectrum calculation circuit 75 with respect to the signal at the current time point (the predetermined time B2) of the arbitrary band, an allowable noise level (second allowable noise level) for an arbitrary band at the current time point (predetermined time B2) is set. To realize this, each of outputs from the energy detection circuits 22, 42 and 62 is supplied to the time period delay circuits 23, 43, 63 and the 5 ms delay circuit 51, and the 2.5 ms delay circuit 71 of the second noise level setting means.

Here, these period delay circuits 23, 43 and 63 serve to delay data respectively supplied thereto every time period of, for example, 10 ms which is the processing unit for the predetermined time period. Further, outputs from the time period delay circuits 43 and 63 are supplied to synthesis circuits 50 and 70, respectively. The synthesis circuits 50 and 70 synthesize data of the time blocks (5 ms, 2.5 ms blocks) at the FFT circuits 40 and 60 so that they become in correspondence with data of 10 ms, respectively. Further, the 5 ms delay circuit 51 carries out delay every 5 ms block. An output from the 5 ms delay circuit 51 is supplied to the selection circuit 52. The selection circuit 52 carries out a switching selection such that in the case where data of the 5 ms block supplied thereto are the forward block data within a predetermined time period being processed, those data are caused to be passed therethrough, and in the case where data of the 5 ms block supplied thereto are the backward block data within a preceding time period of the predetermined time period, those data are not caused to be passed therethrough. Thus, assuming that the predetermined period being processed is the period B2 of Figure 3, the selection circuit 52 carries out a selection such that when 5 ms block data supplied thereto are the block b (2, 2, 1) in Figure 3, that circuit is turned ON, and when the above data are the block b (1, 2, 2), that circuit is turned OFF. The 2.5 ms delay circuit 71 carries out delay every block of 2.5 ms. Outputs from the 2.5 ms delay circuit 71 are supplied in sequence to the 2.5 ms delay circuits 72 and 73. Each of the outputs from the 2.5 ms delay circuits 71, 72 and 73 is supplied to the synthesis/selection circuit 74. The synthesis/selection circuit 74 carries out a switching selection such that in the case where 2.5 ms block data supplied thereto are the backward block b (1, 3, 4) within a preceding predetermined time period of, for example, the predetermined period B2, that circuit is turned OFF, and in the case where those data are the blocks b (2, 3, 1), b(2, 3, 2) and b (2, 3, 3) within the predetermined time period B2, that circuit is turned ON. At the same time, when, for example, data of the block b (2, 3, 2) are supplied to the synthesis/selection circuit 74, the synthesis/selection circuit 74 synthesize this block and the forward block (2, 3, 1); when data of the block b (2, 3, 3) are supplied to the synthesis/selection circuit 74, it synthesizes this block and the forward two blocks b (2, 3, 1) and b (2, 3, 2); and when data of the block b (2, 3, 4) are supplied to the synthesis/selection circuit 74, it synthesizes this block and the forward three blocks b (2, 3, 1), b (2, 3, 2) and b (2, 3, 2).

An output from the time period delay circuit 23 is supplied to the weighting synthesis circuit 24, outputs from the synthesis circuit 50 and the selection circuit 52 are supplied to the weighting synthesis circuit 44, and outputs from the synthesis circuit 70 and the synthesis/selection circuit 74 are supplied to the weighting synthesis circuit 64. Further, data from the masking spectrum calculation circuit 75 are also supplied to respective weighting synthesis circuits 24, 44 and 64. Here, respective weighting synthesis circuits 24, 44 and 64 synthesize weighting coefficients in which the masking effects on the frequency base and the time base are taken into consideration with respect to data supplied thereto. Namely, these weighting coefficients are coefficients set by taking the masking effect into consideration. For example, in the case where a signal for a predetermined time period and time blocks preceding or succeeding a signal for a current predetermined period and respective time blocks is normalized, so that it takes a value of 1, a weighting coefficient corresponding to a level exerted on the signal for the current predetermined time period and the time blocks based on the masking (masking and temporal masking with respect to a signal on the frequency base, or the like) on the frequency axis and the time axis by the signal for the preceding or succeeding predetermined time period and time blocks is weighted with respect to the signal for the preceding or succeeding predetermined time period and time blocks. Thus, the allowable noise level (masking spectrum) utilizing the masking effects on the frequency axis and the time axis can be set.

It is to be noted that while the above-described masking spectrum in which the masking effect is taken into consideration is determined within the same critical band, that spectrum is permitted to be a spectrum in which masking between other critical bands is taken into consideration.

Outputs from the weighting synthesis circuits 24, 44 and 64 are further supplied through the synthesis circuits 25, 45 and 65 to subtracters 27, 47 and 67, respectively. To the subtracters 27, 47 and 67, outputs from the respective energy detection circuits 22, 42 and 62, that is, the previously described bark spectrum SB are also supplied through the delay circuits 31, 56 and 81, respectively. Accordingly, when subtractive calculations between the masking spectrum and the bark spectrum SB of the first and second allowable noise levels are carried out at the subtracters 27, 47 and 67, the portions of the bark spectrum SB below the level indicated by each level of the masking spectrum MS are masked as shown in Figure 6.

Outputs from the subtracters 27, 47 and 67 are supplied to the quantization circuits 29, 49 and 69 through ROMs 28, 48 and 68, respectively. The ROMs 28, 48 and 68 store therein allocation bit number information in quantization at the quantization circuits 29, 49 and 69 to output allocation bit number information corresponding to outputs from the subtracters 27, 47 and 67, respectively. Thus, the quantization circuits 29, 49 and 69 quantize FFT coefficient data supplied through the delay circuits 30, 55 and 80 by allocating bit numbers corresponding to outputs from the respective subtracters 27, 47 and 67. In other words, the quantization circuits 29, 49 and 69 quantize components of respective bands by the number of bits allocated in dependence upon level differences between energies in every band of the critical band allowable noise levels, in which the masking effects on the frequency axis and the time axis are taken into consideration. It is to be noted that this bit allocation is not carried out for the predetermined time period, and the number of bits used for respective predetermined time periods is determined in advance. Accordingly, bit allocation is carried out within one predetermined time period. here the delay circuits 30, 55 and 80 are provided by taking into account delay quantities at respective circuits succeeding the critical band division circuits 21, 41 and 61. Further, the delay circuits 31, 56 and 81 are provided by taking into consideration delay quantities at respective circuits succeeding the time period delay circuits 23, 43 and 63, the 5 ms delay circuit 51, the 2.5 ms delay circuit 71, and the masking spectrum calculation circuit 75.

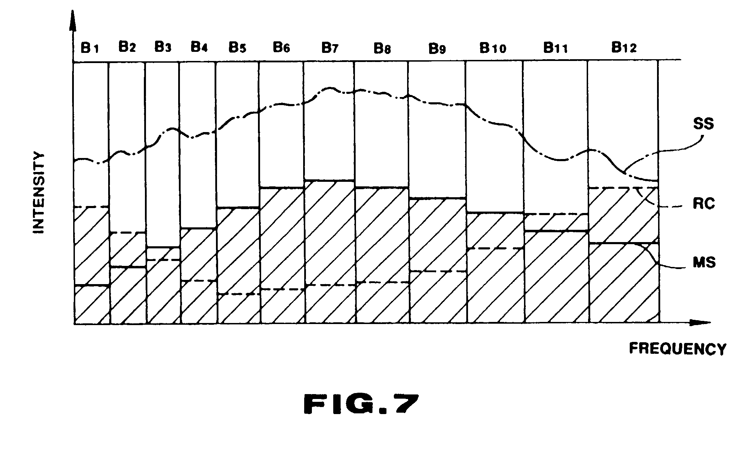

In synthesis at the synthesis circuits 25, 45 and 65, it is possible to synthesize data indicating the so-called minimum audible curve (equi-loudness curve) RC of human hearing, as shown in Figure 7, supplied from minimum audible curve generation circuits 26, 46 and 66 and the above-mentioned masking spectrum. Accordingly, by both synthesizing the minimum audible curve RC and the masking spectrum MS, the allowable noise level can be down to the portion indicated by slanting lines in the figure. Thus, the number of bits allocated to the portion indicated by slanting lines in the figure can be reduced in quantization. Figure 7 also shows a signal spectrum SS at the same time. Further, in this embodiment, there may be employed a configuration such that the above-described synthesis processing of the minimum audible curve is not carried out. In this case, the minimum audible curve generation circuits 26, 46 and 66 and the synthesis circuits 25, 45 and 65 in the configuration of Figure 1 become unnecessary.

Respective outputs from the quantization circuits 29, 49 and 69 quantized by the adaptively allocated bit number in this way are synthesized at a synthesis circuit 90, and an output thus synthesized is then outputted as a coded output from the output terminal 2.

As described above, the effect with the embodiment is that time resolution is improved in a higher frequency band, and the frequency resolution is improved in a lower frequency band. Thus, processing suitable for human hearing can be carried out. In addition, at least one datum at the second noise level setting means is caused to be data preceding in time, and the second noise level setting means sets each second allowable noise level on the basis of energies of data which are the same in terms of the frequency components for periods different in time. Thus, processing can be effected in a short time.

## Claims

1. A digital signal encoder comprising:
first frequency analysis means (10) of the non-block type for carrying out frequency analysis of an input digital signal;
second frequency analysis means (20, 40, 60) of the block type for further carrying out frequency analysis of frequency components analyzed by said first frequency analysis means (10) ;
first noise level setting means (75) for setting a first allowable noise level on the basis of the energy of each frequency component within a predetermined time period of outputs from said second frequency analysis means (20, 40, 60);
second noise level setting means (23, 43, 63, 50, 70, 51, 71, 72, 73, 52, 74, 22, 44, 64) for setting a second allowable noise level of each frequency component within said predetermined time period on the basis of the energy of at least one of data preceding in time and data succeeding in time of outputs from said second frequency analysis means (20, 40, 60); and
quantization means (29, 49, 69) for quantizing an output from said second frequency analysis means (20, 40, 60);
the quantization characteristic of said quantization means being set on the basis of outputs from said first and second noise level setting means (75, 23, etc.).

2. An encoder according to claim 1 wherein said first frequency analysis means (10) comprises band division means for dividing said input digital signal into signal components in a plurality of frequency bands, including at least one filter (11, 12), and said second frequency analysis means (20, 40, 60) comprises fast Fourier transform means for carrying out fast Fourier transformation of signal components every block.

3. An encoder according to claim 2 wherein said band division means carries out a division such that the bandwidth becomes large as the frequency band shifts to a higher frequency, said fast Fourier transform means carrying out processing such that the block time length where said fast Fourier transform processing is conducted becomes small as the frequency band shifts to a higher frequency.

4. An encoder according to claim 1, claim 2 or claim 3 wherein said at least one datum at said second noise level setting means (23, etc.) is data preceding in time.

5. An encoder according to any one of the preceding claims wherein said second noise level setting means (23, etc.) sets said second allowable noise level on the basis of energies of data which are the same in terms of frequency components for periods different in time.

6. An encoder according to any one of the preceding claims which comprises a critical band division circuit (21, 41, 61) for further dividing as a whole an output from said second frequency analysis means (20, 40, 60) into signal components in critical bands.

7. An encoder according to claim 6 wherein said first noise level setting means (23, etc.) sets said first allowable noise level on the basis of an energy determined by a sum total of amplitude values in respective bands of said critical bands.

8. An encoder according to claim 6 wherein said second noise level setting means (23, etc.) sets said second allowable noise level in every said critical band.

9. An encoder according to claim 6 wherein said second allowable noise level in an arbitrary band of said critical bands is set on the basis of said second allowable noise level in another of said critical bands.

10. An encoder according to claim 8 wherein the quantization characteristic of said quantization means (29, 49, 69) is set in dependence upon level differences between said energies in every band of said critical bands, and said first and second allowable noise levels.

11. An encoder according to any one of the preceding claims wherein the quantization characteristic of said quantization means (29, 49, 69) is such that as the frequency band shifts to a higher frequency, the number of bits allocated becomes smaller.

12. An encoder according to any one of the preceding claims wherein said first allowable noise level is a masking level on the frequency axis based on human hearing.

13. An encoder according to any one of the preceding claims wherein said second allowable noise level is a masking level on the time axis based on human hearing.

14. An encoder according to claims 12 and 13 wherein said first and second allowable noise levels are obtained by synthesizing masking levels on said frequency and time bases and a minimum audible curve based on human hearing.

15. An encoder according to any one of the preceding wherein said at least one filter of said first frequency analysis means (20, 40, 60) is a mirror filter.

16. An encoder according to any one of claims 1 to 14 wherein said at least one filter of said first frequency analysis means (20, 40, 60) is a band-pass filter.

## Patentansprüche

1. Digitaler Signalcodierer, mit:
einer ersten Frequenzanalyseeinrichtung (10) vom Nicht-Block-Typus, um eine Frequenzanalyse eines digitalen Eingangssignals durchzuführen;
einer zweiten Frequenzanalyseeinrichtung (20, 40, 60) vom Blocktypus, um weiter eine Frequenzanalyse von Frequenzkomponenten durchzuführen, die durch die erste Frequenzanalyseeinrichtung (10) analysiert wurden;
einer ersten Rauschpegel-Einstelleinrichtung (75), um einen ersten zulässigen Rauschpegel auf der Basis der Energie von jeder Frequenzkomponente innerhalb einer vorgegebenen Zeitperiode von Ausgangssignalen der zweiten Frequenzanalyseeinrichtung (20, 40, 60) einzustellen;
einer zweiten Rauschpegel-Einstelleinrichtung (23, 43, 63, 50, 70, 51, 71, 72, 73, 52, 74, 22, 44, 64), um einen zweiten zulässigen Rauschpegel jeder Frequenzkomponente innerhalb der vorgegebenen Zeitperiode auf der Basis der Energie von zumindest einem der Datenwörter, die zeitlich vorhergehen, und von Daten, die zeitlich folgen, von Ausgangssignalen von der zweiten Frequenzanalyseeinrichtung (20, 40, 60) einzustellen; und
einer Quantisierungseinrichtung (29, 49, 69), um ein Ausgangssignal von der zweiten Frequenzanalyseeinrichtung (20, 40, 60) zu quantisieren;
wobei die Quantisierungscharakteristik der Quantisierungseinrichtung auf der Basis der Ausgangssignale von der ersten und zweiten Rauschpegel-Einstelleinrichtung (75, 23, usw.) eingestellt wird.

2. Codierer nach Anspruch 1, wobei die erste Frequenzanalyseeinrichtung (10) eine Bandteilungseinrichtung aufweist, um das digitale Eingangssignal in Signalkomponenten in mehrere Frequenzbänder zu unterteilen, wobei sie zumindest ein Filter (11, 12) aufweist, und wobei die zweite Frequenzanalyseeinrichtung (20, 40, 60) eine schnelle Fourier-Transformationseinrichtung aufweist, um die schnelle FourierTransformation von Signalkomponenten blockweise durchzuführen.

3. Codierer nach Anspruch 2, wobei die Bandteilungseinrichtung eine Teilung derart durchführt, daß die Bandbreite groß wird, wenn sich das Frequenzband zu einer höheren Frequenz verschiebt, wobei die schnelle Fourier-Transformationseinrichtung eine Verarbeitung derart ausführt, daß die Blockzeitlänge, in der die schnelle Fourier-Transformationsverarbeitung durchgeführt wird, klein wird, wenn sich das Frequenzband zu einer höheren Frequenz verschiebt.

4. Codierer nach Anspruch 1, 2 oder 3, wobei zumindest das eine Datenwort in der zweiten Rauschpegel-Einstelleinrichtung (23, usw.) Daten sind, die zeitlich vorhergehen.

5. Codierer nach einem der vorhergehenden Ansprüche, wobei die zweite Rauschpegel-Einstelleinrichtung (23, usw.) den zweiten zulässigen Rauschpegel auf der Basis der Energien von Daten einstellt, die gleich sind in Hinblick auf Frequenzkomponenten für Perioden, die zeitlich unterschiedlich sind.

6. Codierer nach einem der vorhergehenden Ansprüche, der eine Grenzband-Teilungsschaltung (21, 41, 61) aufweist, um außerdem ein Ausgangssignal von der zweiten Frequenzanalyseeinrichtung (20, 40, 60) in Signalkomponenten in Grenzbändern als Ganzes zu teilen.

7. Codierer nach Anspruch 6, wobei die erste Rauschpegel-Einstelleinrichtung (23, usw.) den ersten zulässigen Rauschpegel auf der Basis einer Energie einstellt, die durch eine Gesamtsumme der Amplitudenwerte in entsprechenden Bändern der Grenzbänder bestimmt wird.

8. Codierer nach Anspruch 6, wobei die zweite Rauschpegel-Einstelleinrichtung (23, usw.) den zweiten zulässigen Rauschpegel in jedem Grenzband einstellt.

9. Codierer nach Anspruch 6, wobei der zweite zulässige Rauschpegel in einem beliebigen Band der Grenzbänder auf der Basis des zweiten zulässigen Rauschpegels in einem anderen der Grenzbänder eingestellt wird.

10. Codierer nach Anspruch 8, wobei die Quantisierungscharakteristik der Quantisierungseinrichtung (29, 49, 69) in Abhängigkeit von Pegelunterschieden zwischen Energien in jedem Band der Grenzbänder und dem ersten und zweiten zulässigen Rauschpegel eingestellt wird.

11. Codierer nach einem der vorhergehenden Ansprüche, wobei die Quantisierungscharakteristik der Quantisierungseinrichtung (29, 49, 69) derart ist, daß, wenn sich das Frequenzband zu einer höheren Frequenz verschiebt, die Anzahl der zugeteilten Bits kleiner wird.

12. Codierer nach einem der vorhergehenden Ansprüche, wobei der erste zulässige Rauschpegel ein Verdeckungspegel über der Frequenzachse ist, der auf menschlichem Hören basiert.

13. Codierer nach einem der vorhergehenden Ansprüche, wobei der zweite zulässige Rauschpegel ein Verdeckungspegel über der Zeitachse ist, der auf menschlichem Hören basiert.

14. Codierer nach Anspruch 12 und 13, wobei der erste und zweite zulässige Rauschpegel durch Synthese von Verdeckungspegeln auf der Grundlage der Frequenz und Zeit und einer auf menschlichem Hören basierenden Minimal-Hörbarkeitskurve erhalten wird.

15. Codierer nach einem der vorhergehenden Ansprüche, wobei zumindest ein Filter der ersten Frequenanalyseeinrichtung (20, 40, 60) ein Spiegelfilter ist.

16. Codierer nach einem der Ansprüche 1 bis 14, wobei zumindest ein Filter der Frequenzanalyseeinrichtung (20, 40, 60) ein Bandpaßfilter ist.

## Revendications

1. Codeur de signaux numériques, comprenant:
- des premiers moyens d'analyse de fréquence (10) du type non-bloc pour effectuer une analyse de fréquence d'un signal numérique d'entrée;
- des deuxièmes moyens d'analyse de fréquence (20, 40, 60) du type bloc pour effectuer en outre une analyse de fréquence des composantes de fréquence analysées par lesdits premiers moyens d'analyse de fréquence (10);
- des premiers moyens d'établissement de niveau de bruit (75) pour établir un premier niveau de bruit admissible sur la base de l'énergie de chaque composante de fréquence dans une période de temps prédéterminée des signaux de sortie desdits deuxièmes moyens d'analyse de fréquence (20, 40, 60);
- des deuxièmes moyens d'établissement de niveau de bruit (23, 43, 63, 50, 70, 51, 71, 72, 73, 52, 74, 22, 44, 64) pour établir un deuxième niveau de bruit admissible de chaque composante de fréquence dans ladite période de temps prédéterminée sur la base de l'énergie d'au moins une des données précédant dans le temps et des données suivant dans le temps des signaux de sortie desdits deuxièmes moyens d'analyse de fréquence (20, 40, 60); et
- des moyens de quantification (29, 49, 69) pour quantifier un signal de sortie desdits deuxièmes moyens d'analyse de fréquence (20, 40, 60),
la caractéristique de quantification desdits moyens de quantification étant établie sur la base des signaux de sortie desdits premiers et deuxièmes moyens d'établissement de niveau de bruit (75, 23, etc.).

2. Codeur selon la revendication 1, dans lequel lesdits premiers moyens d'analyse de fréquence (10) comprennent des moyens de division en bandes pour diviser ledit signal numérique d'entrée en composantes de signal dans une pluralité de bandes de fréquences, comprenant au moins un filtre (11, 12), et lesdits deuxièmes moyens d'analyse de fréquence (20, 40, 60) comprennent des moyens de transformée rapide de Fourier pour effectuer la transformation rapide de Fourier des composantes de signal de chaque bloc.

3. Codeur selon la revendication 2, dans lequel lesdits moyens de division en bandes effectuent une division de telle manière que la largeur de bande deviennent grande au fur et à mesure que la bande de fréquences se déplace vers une fréquence plus élevée, lesdits moyens de transformée de Fourier exécutant un traitement tel que la longueur de temps de bloc dans lequel ledit traitement de transformée de Fourier rapide est exécuté devienne petite au fur et à mesure que la bande de fréquences se déplace vers une fréquence plus élevée.

4. Codeur selon la revendication 1, la revendication 2 ou la revendication 3, dans lequel ladite au moins une donnée dans lesdits deuxièmes moyens d'établissement de niveau de bruit (23, etc.) est une donnée précédant dans le temps.

5. Codeur selon l'une quelconque des revendications précédentes, dans lequel lesdits deuxièmes moyens d'établissement de niveau de bruit (23, etc.) établissent ledit deuxième niveau de bruit admissible sur la base des énergies des données qui sont les mêmes en termes de composantes de fréquence pour des périodes différentes dans le temps.

6. Codeur selon l'une quelconque des revendications précédentes, comprenant un circuit de division de bande critique (21, 41, 61) pour diviser en outre comme un tout un signal de sortie desdits deuxième moyens d'analyse de fréquence (20, 40, 60) en composantes de signal dans des bandes critiques.

7. Codeur selon la revendication 6, dans lequel lesdits premiers moyens d'établissement de niveau de bruit (23, etc.) établissent ledit premier niveau de bruit admissible sur la base d'une énergie déterminée par la somme totale des valeurs d'amplitude dans les bandes respectives desdites bandes critiques.

8. Codeur selon la revendication 6, dans lequel lesdits deuxièmes moyens d'établissement de niveau de bruit (23, etc.) établissent ledit deuxième niveau de bruit admissible dans chacune desdites bandes critiques.

9. Codeur selon la revendication 6, dans lequel ledit deuxième niveau de bruit admissible dans une bande arbitraire parmi lesdites bandes critiques est établi sur la base dudit deuxième niveau de bruit admissible dans une autre desdites bandes critiques.

10. Codeur selon la revendication 8, dans lequel la caractéristique de quantification desdits moyens de quantificaitno (29, 49, 69) est établie en fonction des différences de niveau entre lesdites énergies dans chacune desdites bandes critiques et lesdits premier et deuxième niveaux de bruit admissibles.

11. Codeur selon l'une quelconque des revendications précédentes, dans lequel la caractéristique de quantification desdits moyens de quantification (29, 49, 69) est telle qu'au fur et à mesure que la bande de fréquences se déplace vers une fréquence plus élevée, le nombre de binaires alloués devient plus petit.

12. Codeur selon l'une quelconque des revendications précédentes, dans lequel ledit premier niveau de bruit admissible est un niveau de masquage suivant l'axe des fréquences sur la base de l'oreille humaine.

13. Codeur selon l'une quelconque des revendications précédentes, dans lequel ledit deuxième niveau de bruit admissible est un niveau de masquage suivant l'axe des temps sur la base de l'oreille humaine.

14. Codeur selon les revendications 12 et 13, dans lequel lesdits premier et deuxième niveaux de bruit admissibles sont obtenus en synthétisant des niveaux de masquage sur lesdites bases de fréquence et de temps et une courbe de seuil d'audibilité basée sur l'oreille humaine.

15. Codeur selon l'une quelconque des revendications précédentes, dans lequel ledit au moins un filtre desdits premiers moyens d'analyse de fréquence (20, 40, 60) est un filtre miroir.

16. Codeur selon l'une quelconque des revendications 1 à 14, dans lequel ledit au moins un filtre desdits premiers moyens d'analyse de fréquence (20, 40, 60) est un filtre passe-bande.
